# EUROPÄISCHE PATENTSCHRIFT

(11) **EP 1 376 103 B1**
(45) Veröffentlichungstag und Bekanntmachung des Hinweises auf die Patenterteilung: **26.07.2006**
(21) Anmeldenummer: 03013754.1
(22) Anmeldetag: 17.06.2003
(51) Int. Cl.: G01N 21/896, G01N 21/45, G01N 21/23

(54) **Verfahren zur Bestimmung lokaler Strukturen in optischen Kristallen**
Method for determining local structures in optical crystals
Procédé pour déterminer des structures locales dans des cristaux optiques

(30) Priorität: 19.06.2002 DE 10227345
(43) Veröffentlichungstag der Anmeldung: 02.01.2004
(73) Patentinhaber: Schott AG, 55122 Mainz (DE)
(72) Erfinder: Mörsen, Ewald, Dr., 55130 Mainz (DE); Engel, Axel, Dr., 55218 Ingelheim (DE); Lemke, Christian, 07743 Jena (DE); Grabosch,Günter, 55122 Mainz (DE)
(74) Vertreter: Fuchs Mehler Weiss & Fritzsche

(56) Entgegenhaltungen:
- DE-C- 19 501 158
- US-A- 3 468 610
- ENGEL A ET AL: "Present and future industrial metrology needs for qualification of high-quality optical microlithography materials" OPTICAL METROLOGY ROADMAP FOR THE SEMICONDUCTOR, OPTICAL, AND DATA STORAGE INDUSTRIES II, SAN DIEGO, CA, USA, 2-3 AUG. 2001, Bd. 4449, Seiten 1-6, XP002280119 Proceedings of the SPIE - The International Society for Optical Engineering, 2001, SPIE-Int. Soc. Opt. Eng, USA ISSN: 0277-786X
- NISHIDA Y ET AL: "Development of a two-dimensional birefringence distribution measurement system in laser-diode pumped solid-state laser material" REVIEW OF SCIENTIFIC INSTRUMENTS, MAY 2001, AIP, USA, Bd. 72, Nr. 5, Seiten 2387-2391, XP002280120 ISSN: 0034-6748

## Beschreibung

Die Erfindung betrifft ein Verfahren zur Bestimmung lokaler Strukturen in optischen Materialien, insbesondere Kristallen. Insbesondere betrifft die vorliegende Erfindung ein Verfahren zur Bestimmung lokaler Strukturen in Materialien für die Mikrolithographie, z.B. aus CaF₂ sowie damit erhaltene optische Elemente.

Für Anwendungen in der Optik werden sowohl bei Gläsern als auch bei Kristallen neben der Form des geforderten Produkts (als Linse, Prisma und dergleichen mit jeweils genau angegebenen geometrischen Parametern) die optischen Eigenschaften sehr detailliert spezifiziert. Dazu gehören bei Gläsern und Kristallen Eigenschaften wie die Transmission, die Homogenität des Brechungsindexes sowie die innere Qualität, die durch Blasen und Einschlüsse oder Schlieren beeinträchtigt sein kann. Bei Kristallen wird die innere Qualität durch die sogenannten Realstrukturen beschrieben, zu denen Punktdefekte, Versetzungen und Korngrenzen, insbesondere Kleinwinkelkorngrenzen, gehören. Diese Defekte sind, im Gegensatz zu den Defekten im Glas, häufig sehr stark räumlich begrenzt, haben jedoch lokal einen sehr hohen Einfluß auf die damit verbundenen physikalischen Effekte wie Absorptionsverhalten, Homogenität des Brechungsindexes oder die Doppelbrechung.

Die Verwendung von Kristallen für optische Bauteile nimmt ständig zu, insbesondere durch die steigende Anwendung von Wellenlängen, die außerhalb des sichtbaren Bereichs liegen und für die Gläser nicht mehr durchlässig sind. So besteht zum Beispiel eine zunehmende Nachfrage nach monokristallinem Material aus Alkali- und Erdalkalifluoriden (CaF₂, BaF₂, SrF₂ usw.) für UV-Anwendungen wie die UV-Lithographie oder Linsen und Fenster für Bestrahlungs- und Abbildungsgeräte. Gleichermaßen stellen Kristalle im infraroten Spektralbereich die Basis für viele optische Elemente dar.

Insbesondere Calciumfluorid-Einkristalle (CaF₂) werden als Ausgangsmaterial für optische Komponenten in der DUV-Photolithographie (DUV = Deep UV) bei Wellenlängen um und unter 200 nm, insbesondere den Wellenlängen 248 nm, 193 nm und 157 nm der verwendeten Excimerlaser benötigt. Die optischen Komponenten sind üblicherweise Linsen, Prismen und Platten in den sogenannten Steppern oder den Excimerlasern und dienen insbesondere dazu, bei der Herstellung von Halbleiterschaltkreisen die feinen Schaltungsstrukturen der integrierten Schaltungen auf die bei der Photolithographie verwendeten Masken und/oder auf die photolackbeschichteten Halbleiterscheiben optisch abzubilden.

In diesem Anwendungsbereich werden einerseits die Halbleiterscheiben immer größer, wobei zur Zeit bereits 250-mm-Scheiben üblich sind. Andererseits werden die abzubildenden Schaltungsstrukturen immer kleiner; Strukturbreiten von 250 nm sind schon Standard. Daher müssen die optischen Komponenten bzw. schon das Ausgangsmaterial dafür über ihr gesamtes Volumen hinweg (beispielsweise Rundscheiben mit ca. 250 mm Durchmesser und ca. 50 mm Dicke) auch kleinräumig die geforderte Qualität aufweisen.

So müssen CaF₂-Kristalle für die Anwendung in der Projektionsoptik für den UV- und DUV-Bereich frei von groben Fehlern wie Korngrenzen sein. Es kommen zur optischen Verwendung demnach nur Kristalle in Frage, die über ihr ganzes Volumen einkristallin sind. Der Einkristall weist zudem meist eine vom Verwendungszweck bestimmte Wunschorientierung auf, z.B. die kristallographische Orientierung <111>, <100> und <110>. Ob ein solcher Einkristall überhaupt für die gewünschten optischen Zwecke verwendbar ist und falls ja für welche Anwendungen, wird durch die im Bereich der Einkristallinität liegenden lokalen Strukturen wie Störungen und Kristalldefekte entschieden.

Einkristalle sind an sich Körper mit langreichweitiger periodischer Kristallstruktur und damit a priori hoher Homogenität der physikalischen Eigenschaften. Da jedoch bei der Herstellung der Kristalle in einer Kristallzuchtanlage nicht alle Parameter, insbesondere der Wärmefluß, vollständig zu beherrschen sind, bilden sich bei der Kristallisation regelmäßig Fehler im Kristall aus, die sogenannten Realstrukturen. So entstehen zum Beispiel Bereiche mit Spannungsdoppelbrechung und Blöcke mit leicht voneinander abweichenden Kristallorientierungen. Die Orientierungsabweichung liegt in einem Winkel von ca. zwischen 1° und 5°. Solche lokalen Realstrukturen begrenzen die Qualität eines Kristalls in der Praxis. Sie dürfen daher bestimmte Grenzwerte nicht übersteigen, wenn ein solcher Kristall in hochgenauen optischen Systemen wie Projektionsoptiken für Stepper, die bei 248 nm, 193 nm oder 157 nm Wellenlänge arbeiten, Verwendung finden soll.

Die in den genannten Einkristallen zur optischen Verwendung auftretenden lokalen Fehler sind vor allem Anhäufungen von Fehlstellen, Versetzungen, Gleitebenen und Kleinwinkelkorngrenzen. Bei den Versetzungen handelt es sich um statistisch verteilte Defekte und bei den Gleitebenen oder Gleitbändern um flächige Defekte. Kleinwinkelkorngrenzen sind die Grenzflächen, die Kristallbereiche mit relativ geringen Orientierungsunterschieden (weniger als 10 Grad) voneinander trennen. An Kleinwinkelkorngrenzen lagern sich häufig Verunreinigungen an, die im Falle des CaF₂ zum Beispiel CaO-Ausscheidungen sind.

Bei der Charakterisierung von optischen Gläsern spielen die kleinräumigen Strukturen nur eine sehr untergeordnete Rolle, hier wird die Qualität im wesentlichen durch langreichweitige Inhomogenitäten bestimmt. Entsprechend werden auch nur die großräumigen Störungen gemessen, d.h. die Messungen weisen eine nur geringe Ortsauflösung auf.

Die Übertragung der an den Gläsern üblichen Meßmethoden auf Kristalle führt somit dazu, daß kristalltypische Defekte nicht festgestellt werden. Die Folge davon ist, daß bei Qualitätsuntersuchungen im Rahmen der Fertigung immer wieder Ausgangskristalle als gut beurteilt und zur aufwendigen Weiterbearbeitung freigegeben werden, wobei sich oft nach dem Einbau als optische Komponente herausstellt, daß diese nicht den geforderten Ansprüchen genügen. Da jedoch auch in Gläsern sowie anderen optischen - auch nicht-kristallinen - Materialien kleinräumige Defekte auftreten, die in optischen Systemen mit hoher Schärfe stören, lassen sich diese mit den vorgenannten Methoden nicht erkennen.

Methoden des Stands der Technik zur Bestimmung lokaler Strukturen werden im Folgenden zitiert.

Das Patent US 3,468,610 beschreibt ein optisches Testinstrument, mit dem die Spannungsdoppelbrechung mittels einer Polarisation sichtbar gemacht werden kann. Dabei wird der zu untersuchende Gegenstand mit divergentem Licht durchstrahlt und nach Reflexion an einem Hohlspiegel auf einem Bildschirm sichtbar gemacht. Durch die Anwendung üblicher Polarisationsfilter kann nun eine Veränderung der Schwingungsebene des Lichtes, wie an Spannungsdoppelbrechung hervorrufenden Kristallstörungen erfolgt, sichtbar gemacht und bestimmt werden.

Die Arbeit von Engel, Mörsen, Jordanov und Knapp (Proceedings of the SPIE, Bd. 4449, Seiten 1-6) beschreibt die Bestimmung von Homogenität, insbesonders der Spannungsdoppelbrechung, mit einem besonderen Interferometer nämlich dem IS Polar RPA 2000.

Derartige lokale, kleinräumige Störungen der Struktur von "Einkristallen" sind somit für die Verwendbarkeit eines Kristalls zum Beispiel in Projektionsoptiken für die Mikrolithographie im UV-Bereich und im tiefen UV-Bereich, das heißt bei Wellenlängen kleiner 200 nm wesentlich entscheidend.

Aufgabe der Erfindung ist es, ein Verfahren zu schaffen, mit dem es möglich ist, bereits am optischen Material im wesentlichen alle der oben beschriebenen Realstrukturen zu erfassen, die die Qualität des Materials im Hinblick auf die gewünschte optische Verwendung beeinflussen. Dies soll insbesondere bereits am optischen Rohmaterial durchführbar sein, bevor dieses zu einem optischen Element weiterverarbeitet wird.

Diese Aufgabe wird erfindungsgemäß mit dem im Patentanspruch 1 angegebenen Verfahren gelöst. Vorteilhafte Ausgestaltungen des Verfahrens sind in den Unteransprüchen beschrieben.

Die Erfindung beruht somit im wesentlichen auf einer Kombination mehrerer Bestimmungen. Im einzelnen sind das eine visuelle Bestimmung der Schlieren mittels weißem Licht, die eine erste Grobsichtung darstellt und die subjektiv vom Beobachter durchgeführt wird. Diese Bewertung wird mit einer beliebigen, insbesondere geringen, Ortsauflösung durchgeführt, die nur durch die visuelle Wahrnehmung des Auges des Beobachters begrenzt wird. Durch diese Grobsichtung lassen sich bereits Materialscheiben aussortieren, deren Qualität auf keinen Fall die geforderten Werte erreicht. Diese Materialscheiben brauchen dann auch nicht mehr die mehr oder weniger aufwendigen Messungen mit hoher Ortsauflösung in den Stufen zwei und drei durchlaufen.

In einem zweiten Schritt, der auf der Polarisationsmethode beruht, werden Scheiben des optischen Materials einer Lasermessung unterworfen. Auch hier wird anhand der Polarisation des durchtretenden Lichts die Spannungsdoppelbrechung bestimmt, jedoch nunmehr mit einer Ortsauflösung von üblicherweise mindestens 0,5 mm, zweckmäßigerweise mindestens 0,3 mm, vorzugsweise kleiner 0,2 mm und noch besser kleiner 0,1 mm. Dazu wird die zu untersuchende Materialscheibe mit einem Laserstrahl durchstrahlt und der durchtretende Laserstrahl punktförmig in einem Raster von Pixeln erfaßt bzw. bestimmt. Die Abstände der abgetasteten Pixel, sowie die Dicke des Laserstrahls bestimmen dabei die Ortsauflösung der lokalen Spannungsdoppelbrechung. Dadurch werden hier auch kleine lokale Strukturen entdeckt, die bei den bisherigen Verfahren nicht zu erkennen waren.

Aufgrund dieser Vorgehensweise ist es nun möglich, nicht nur Höchst- und Durchschnittswerte für die Störungen in einer Material- bzw. Kristallscheibe anzugeben, sondern diese Störungen auch genau zu lokalisieren. Materialien bzw. Kristalle, die an Einzelstellen schlechte Werte aufweisen, können bereits hier aussortiert werden und ggf. einer anderen Verwendung zugeführt werden, für die kleinere Scheiben benötigt werden. Störungen sind hierbei insbesondere lokale Defekte und Fehler in der Materialmatrix bzw. Kristallstruktur, welche die optische Homogenität des Materials stören.

Der Grenzwert für die Spannungsdoppelbrechung sollte so gering als möglich sein und 1,0 nm/cm bzw. 0,5 nm/cm, vorzugsweise 0,4 nm/cm und insbesondere 0,3 nm/cm nicht überschreiten.

Schließlich wird die Materialscheibe einer interferometrischen Messung unterworfen, bei der die Probe ebenfalls abgerastert wird. Auch hier erfolgt eine Messung mit hoher Ortsauflösung. Bei der Interferometrie kann die ganze Probe gleichzeitig mit einer Lichtquelle bestrahlt und das Bild, das Laufzeit- oder Phasendifferenzinformationen enthält, mit einer CCD-Kamera als Gesamtbild digital aufgenommen werden. Das solcherart aufgenommene digitale Bild läßt sich punktweise anhand der Helligkeitswerte beurteilen und solcherart auch die ortsaufgelösten Meßwerte erhalten. Ein derartiges Verfahren ist in der nicht vorveröffentlichten DE-A 101 11 450 der gleichen Anmelderin beschrieben.

Es werden erfindungsgemäß somit auch lokale, kleinräumige Strukturen mit hoher Genauigkeit und hoher Ortsauflösung spannungsoptisch und interferometrisch erfaßt. Die Fehlererfassung erfolgt bereits am Ausgangsmaterial für die optischen Komponenten, das heißt im Falle von CaF₂ am Kristall selbst bzw. an den aus dem zu untersuchenden Material herausgeschnittenen Scheiben. Das erfindungsgemäße Verfahren ist jedoch nicht nur für Kristalle geeignet, sondern allgemein zur Charakterisierung bzw. Eignungsprüfung von optische Materialien verwendbar. Derartige optische Materialien sind üblicherweise Glas, Quarz, Quarzglas, optische Kunststoffe sowie Kristalle, insbesondere Halogenidkristalle und Oxidkristalle. Unter den Halogenidkristallen sind Chlorid und insbesondere Fluorid bevorzugt. Des weiteren sind Alkali- und Erdalkali, Oxid- und Halogenidkristalle bevorzugt und zwar insbesonders aus Kalium, Natrium, Lithium, Strontium, Calcium, Magnesium, Barium.

Anhand eines Ausführungsbeispiels und der Zeichnung wird die Erfindung im folgenden näher erläutert. Es zeigen:
Fig. 1 den Verlauf der Spannungsdoppelbrechung über eine CaF₂-Kristallscheibe;
Fig. 2 eine CaF₂-Kristallscheibe mit einer Anzahl von linienförmigen Gleitebenen; und
Fig. 3 eine CaF₂-Kristallscheibe mit einer Anzahl von Kleinwinkelkorngrenzen.

Zur Charakterisierung der optischen Materialien wird in der Regel die Spannungsdoppelbrechung im Material mit Hilfe eines Polariskops oder Polarimeters untersucht. Eine solche Messung erlaubt zwar eine qualitative Bewertung des Materials bzw. Kristalls, jedoch keine oder allenfalls nur eine grobe quantitative Bewertung und vor allem keine vollflächige und genaue Quantifizierung. Eine solche ist jedoch bei Materialien, wie z.B. bei CaF₂-Kristallen, die für die Anwendung in der Projektionsoptik der Photolithographie vorgesehen sind, aufgrund der lokalen Strukturen im Material erforderlich.

Bei Voruntersuchungen wurde festgestellt, daß die lokalen Strukturen eine um einen Faktor zehn oder noch höhere Doppelbrechung aufweisen als fehlerfreie Material- bzw. Kristallbereiche. Diese starken lokalen Änderungen der Eigenschaften, die sich mindernd auf den Kontrast des Systems auswirken, sind besonders kritisch für Anwendungen in der Photolithographie. Darüber hinaus wird in solchen lokalen Strukturen in der Regel auch ein Teil der eingestrahlten Energie absorbiert, was zu einer lokalen Erwärmung der optischen Linse, Prisma, etc. führt und damit auch zu einer lokalen Änderung der Brechwerte und der Abbildungsgenauigkeit.

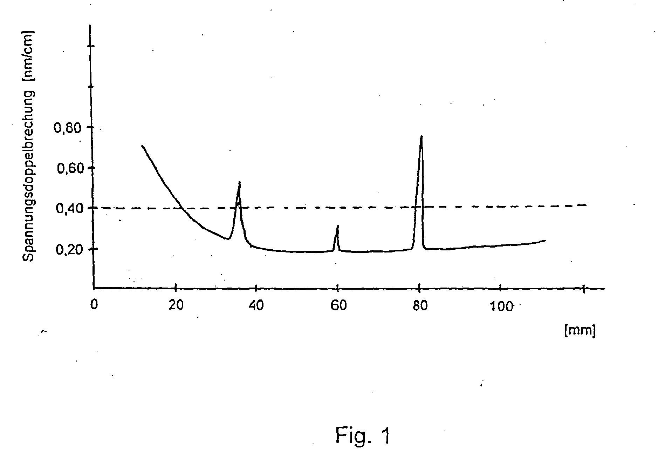

Die Fig. 1 zeigt beispielhaft den Verlauf der Spannungsdoppelbrechung an einer CaF₂-Kristallscheibe in Abhängigkeit vom Ort bei einem Scan über die Scheibe. Die Auswirkungen langreichweitiger Inhomogenitäten, etwa eine Änderung in der chemischen Zusammensetzung, spiegeln sich in der relativ schwach gekrümmten Allgemeinform der Kurve für die Spannungsdoppelbrechung wider. Auf diese Kurve aufgesetzt sind Peaks bzw.

Zacken, die lokale Strukturen und Kristallfehler anzeigen. Diese kurzreichweitigen Inhomogenitäten werden bei der im erfindungsgemäßen Verfahren erreichten Ortsauflösung erfaßt. In einzelnen Fällen kann dort die Spannungsdoppelbrechung ohne weiteres den vorgegebenen Grenzwert von zum Beispiel 40 nm/cm (gestrichelte Linie) weit übersteigen.

Kristalle für die Mikrolithographie sollen lokal in Bereichen kleiner 1 mm Durchmesser, vorzugsweise Bereichen kleiner 0,5 mm Durchmesser, keine Doppelbrechung aufweisen. Generell sollte die Doppelbrechung nur gering und vorzugsweise kleiner als 5 nm/cm sein, insbesondere < 1 nm/cm. Mit anderen Worten sollte die Differenz zwischen zwei nebeneinanderliegenden Meßpunkten vorzugsweise kleiner sein als 5 nm/cm, insbesondere <1 nm/cm. Der Phasenhub der Schlieren in den Kristallen sollte unter 5 nm, vorzugsweise unter 1 nm liegen. Die Werte von lokalen Strukturen sollten höchstens um den Faktor 5 größer sein als der RMS-Mittelwert, vorzugsweise höchstens um den Faktor 3.

Materialien, wie z.B. CaF₂-Kristalle, können analog zum optischen Glas einer visuellen Schlierenkontrolle gemäß der Spezifikation MIL G174-B unterzogen werden. Dabei stellen sich insbesondere die als Kleinwinkelkorngrenzen bezeichneten Defekte heraus. Diese "Schlieren" sind in ihrer Ausprägung häufig den sogenannten C- und D-Schlieren nach MIL G174-B im optischen Glas vergleichbar. Nur schlierenfreie bzw. schlierenarme Kristalle (Grad A 0 schlierenfrei, maximal Grad B) sind zur Anwendung in der Mikrolithographie geeignet. Zur ausreichenden Detektion der Schlieren muß die Messung eine Ortsauflösung von besser 0,2 mm aufweisen.

Um ein besonders reines und möglichst strukturfreies Material für die Mikrolithographie bereitzustellen, müssen daher nicht nur die großflächigen Inhomogenitäten, sondern auch die kleinen Mikrostrukturen vermieden werden, die lokal in einem kleinen, begrenzten Raum auftreten und die beispielsweise durch Gleitebenen oder auch durch Kleinwinkelkorngrenzen gebildet werden, an denen sich dann häufig noch Verunreinigungen abscheiden und die deshalb auch als Schlieren in Erscheinung treten. Um diese Fehler und Mikrostrukturen mit hoher Genauigkeit zu erfassen, wird eine Reihe von Messungen hintereinandergeschaltet.

In einem ersten Schritt werden die aus den gezogenen Kristallen geschnittenen Materialscheiben der visuellen Schlierenkontrolle gemäß der Spezifikation MIL G174-B mit weißem Licht unterzogen. Nur schlierenfreie bzw. schlierenarme Materialien (Grad A 0, maximal Grad B gemäß MIL G174-B) werden den weiteren Messungen zugeführt. Materialien bzw. Materialscheiben, die diese Anforderungen nicht erfüllen, können einem weiteren Temperschritt unterworfen und anschließend noch einmal untersucht werden.

Auf diese Weise erfolgt eine erste Grobsichtung, die zwar lediglich subjektiv vom Beobachter entschieden wird und bei der nur relativ großflächige Fehler erfaßt werden, mit der sich aber Materialscheiben aussortieren lassen, die bereits die Minimalanforderungen nicht erfüllen.

Die Schlierenmessung kann dergestalt automatisch erfolgen, daß das Schattenbild der Probe auf einem Projektionsschirm von einer elektronischen Bildaufnahmeeinrichtung wie einer digitalen CCD-Kamera aufgenommen wird, wobei das Bild der Probe einer Bildbearbeitung unterworfen wird, die den Kontrast der Strukturen im Bild feststellt, und wobei die im Bild festgestellten Kontraste mit Mustern verglichen werden. Das Vergleichsergebnis dient dann zur Bewertung der Probe. Ein derartiges Verfahren ist in der nicht vorveröffentlichten DE-A 101 11 450 der gleichen Anmelderin im Detail beschrieben.

Dabei wird derart vorgegangen, daß eine Probe mit divergentem Licht von einer Lichtquelle durchstrahlt wird, und ein reelles Schattenbild der Probe auf einem Projektionsschirm erzeugt wird, wobei das Schattenbild der Probe auf dem Projektionsschirm von einer elektronischen Bildaufnahmeeinrichtung, wie beispielsweise einer CCD-Kamera, aufgenommen wird. Das von der elektronischen Bildaufnahmeeinrichtung aufgenommene Schattenbild der Probe wird dann einer Bildbearbeitung unterworfen, die jeweils den Bildkontrast von Schlieren feststellt, und die an der jeweiligen Probe gemessenen Bildkontraste werden mit den Bildkontrasten in dem Schattenbild von Schlierenmustern in einer synthetischen Schlierenplatte verglichen und anhand des Vergleichsergebnisses die Schlieren in der Probe des optischen Materials bewertet. Das Vergleichsmuster der synthetischen Schlierenplatte wird üblicherweise interferometrisch vermessen, wobei die interferometrische Messung zur Kalibrierung der an der Probe erfaßten Bildkontraste dient. Vorzugsweise besteht die synthetische Schlierenplatte aus dem gleichen Material wie die zu bewertende Probe aus optischem Material. Es ist aber auch möglich, eine synthetische Schlierenplatte aus einem anderen Material wie die zu bewertende Probe aus optischem Material zu verwenden, und diese Schlierenplatte mit einer synthetischen Schlierenplatte aus dem zu bewertenden Probematerial interferometrisch zu kalibrieren. Die synthetische Schlierenplatte weist vorzugsweise künstliche Schlieren mit einem positiven Phasenhub in Stufen von etwa 5 nm bis etwa 50 nm und Breiten von etwa 0,1 mm bis etwa 0,5 mm bei einer Wellenlänge von 550 nm auf.

Prinzipiell ist es bevorzugt, die Probe bezüglich der optischen Achse des Meßaufbaus für die Schattenmethode in einer Anzahl Richtungen zu kippen und zu drehen.

Bei diesem Schritt kann die Probe auch mit einem Lichtstrahl bestrahlt und der Bildschirm, auf den das Licht nach dem Passieren der Probe auftrifft, von einer CCD-Kamera als Gesamtbild digital aufgenommen werden. Das aufgenommene, digitale Bild läßt sich ebenfalls Bildpunkt für Bildpunkt (Pixel für Pixel) in seine Helligkeitswerte umsetzen.

Sind die im ersten Schritt grob bewerteten Scheiben für ausreichend gut befunden worden, werden sie in einem zweiten Schritt einer Lasermessung mit hoher Ortsauflösung unterzogen.

Der zweite Schritt beruht auf der Polarisationsmethode. Auch hier wird die Spannungsdoppelbrechung anhand der Polarisation des durchtretenden Lichts bestimmt. Dabei wird üblicherweise so vorgegangen, daß über die gesamte Materialscheibe in einem Rasterabstand von höchstens 0,5 mm bis 0,3 mm, vorzugsweise höchstens 0,2 mm und noch besser höchstens 0,1 mm, mit dem monochromatischen Laserstrahl die lokale Spannungsdoppelbrechung kleinräumig gemessen wird. Da der Laserstrahl einen Durchmesser von zum Beispiel 1 mm hat, überlappen sich die einzelnen Meßpunkte entsprechend.

Auf diese Weise werden im zweiten Schritt auch kleine lokale Strukturen sehr genau erfaßt und bestimmt. Dadurch ist es nun möglich, nicht nur Höchst- und Durchschnittswerte der Schlieren in einer Materialscheibe anzugeben, sondern diese Werte können nun auch genau lokalisiert werden. Auf diese Weise ist es möglich, nunmehr auch optische Materialien, wie Kristalle, die lokal an Einzelstellen schlechte Werte aufweisen, auszusortieren. Alternativ kann vorgesehen werden, den Materialkörper bzw. den Kristall so aufzuteilen, daß nur aus den guten Bereichen optische Komponenten hergestellt werden.

Der Grenzwert für die lokale Spannungsdoppelbrechung kann zum Beispiel bei 0,5 nm/cm oder 0,4 nm/cm oder besser bei kleiner als 0,3 nm/cm liegen, so daß sich ein Durchschnittsrauschen von ca. 0,2 nm/cm ergibt.

Hat die untersuchte Materialscheibe auch diesen Test bestanden, wird sie in einem dritten Schritt interferometrisch vermessen. Im Gegensatz zu den ersten beiden Schritten, die Informationen über den Polarisationszustand der Probe bzw. der Lichtstrahlen lieferten, die die Probe durchsetzt haben, liefert die Interferometrie Informationen über den Laufzeitunterschied (die Phasendifferenz) der Lichtstrahlen, die die Probe durchsetzt haben. Diese Information wird vom CCD-Chip einer Digitalkamera erfasst, pixelweise ausgelesen und verarbeitet. Die Rasterpunkt (Pixel) für Rasterpunkt (Pixel) erhaltenen Helligkeitswerte, besser gesagt die Unterschiede in den Helligkeitswerten, geben Auskunft über optische Inhomogenitäten, die die genannten Laufzeitunterschiede hervorrufen. Nach dem bisherigen Stand der Technik wurden für Untersuchungen an optischen Komponenten immer Interferometer mit einer relativ geringen Ortsauflösung verwendet (typisch mehr als 1 mm Pixel-Abstand). Bei dieser geringen Ortsauflösung lassen sich lokale Strukturen nicht mit ausreichender Genauigkeit erfassen, die Messungen ergeben einen Wert für die Homogenität, der im wesentlichen durch die in der Regel gute globale Homogenität des Kristalles bestimmt ist und vor allem die langreichweitige Ordnung wiedergibt. Erst mit einem Interferometer mit hoher Ortsauflösung werden die in der Mikrolithographie störenden lokalen Strukturen festgestellt. Die Ortsauflösung sollte am jeweils technisch optimal Machbaren bzw. technisch und ökonomisch Sinnvollen ausgerichtet werden und je nach Vergrößerung mindestens 0,32 mm/Pixel, vorzugsweise mindestens 0,2 mm/Pixel, und insbesonders mindestens 0,1 mm/Pixel betragen.

Alle geschilderten Messungen erfolgen an Materialscheiben mit einer polierten Oberfläche die eine geringe Rauhigkeit aufweist. Eine zweckmäßige RMS-Rauhigkeit der Oberfläche beträgt ≤ 4nm und vorzugsweise ≤ 2 nm, wobei ≤ 1 nm besonders bevorzugt ist.

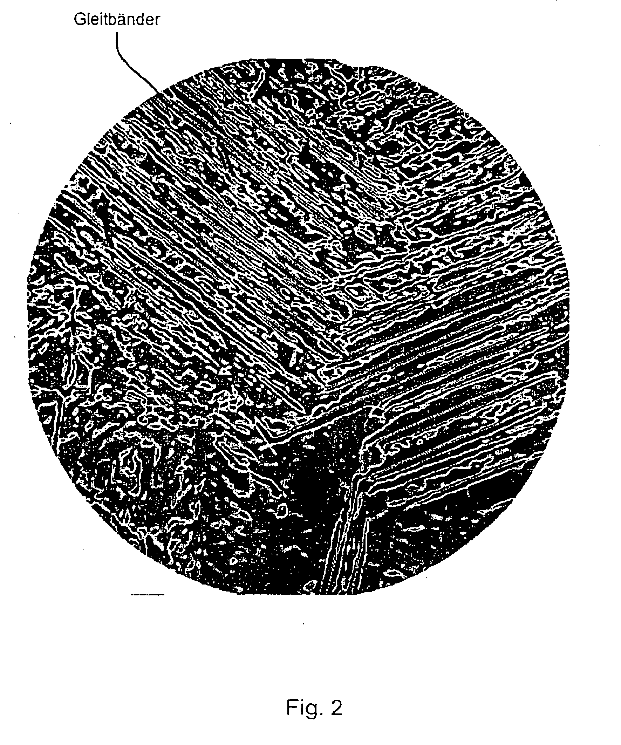

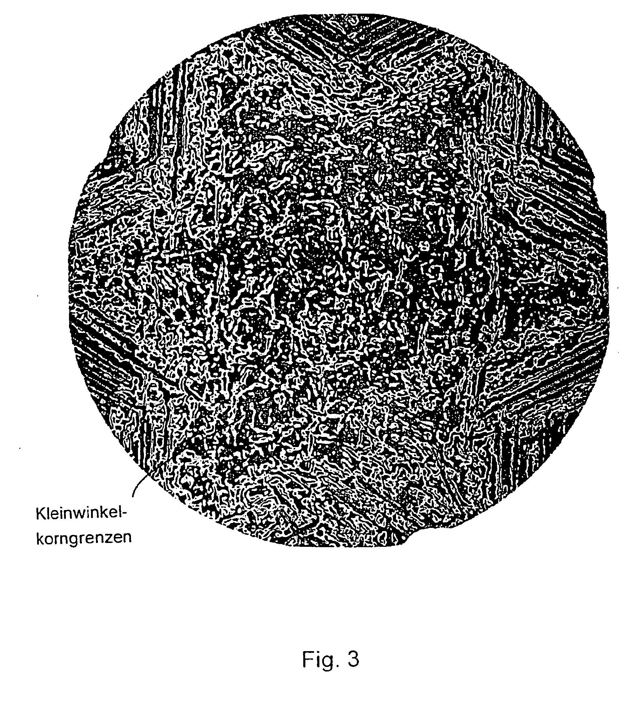

Die Fig. 2 und 3 der Zeichnung zeigen beispielhaft Bilder von Feinstrukturen in einer CaF₂-Kristallscheibe. Die im Durchlicht mit polarisiertem monochromatischen Laserlicht (zweckmäßigerweise HeNe 632,8 nm) gewonnenen Bilder zeigen jeweils die Spannungsdoppelbrechung in der Materialscheibe. Prinzipiell sind auch andere Wellenlängen anwendbar. Die Fig. 2 zeigt eine Kristallscheibe mit einer Anzahl von Gleitebenen und die Fig. 3 eine Kristallscheibe mit vielen Kleinwinkelkorngrenzen. Die Gleitebenen der Fig. 2 stellen sich durch die geraden, bandartigen Strukturen dar, die über einen großen Teil des Kristallquerschnitts laufen. Die Fig. 3 zeigt eine Kristallscheibe, die am Rand auch einige Gleitebenen aufweist, in der Mitte dieser Kristallscheibe dominieren jedoch unregelmäßige wurmartige Kringel, die Kleinwinkelkorngrenzen darstellen.

Mit dem erfindungsgemäßen Verfahren ist es auch möglich, Linsen, Prismen, rechteckige Platten, Lichtleitstäbe, optische Fenster sowie optische Geräte für die DUV-Lithographie herzustellen. Das Verfahren findet daher auch insbesondere Anwendung zur Herstellung von Steppern und Excimerlasern und somit auch zur Herstellung von integrierten Schaltungen sowie elektronischer Geräte wie Computerchips enthaltenden Computern sowie anderer elektronischer Geräte, welche chipartige integrierte Schaltungen enthalten.

## Patentansprüche

1. Verfahren zur Bestimmung lokaler Strukturen in optischen Materialien, insbesondere in Kristallen, **dadurch gekennzeichnet, dass**
- in einem ersten Schritt eine visuelle Bestimmung von Schlieren im Material durchgeführt wird, indem man es
- mit divergentem Licht von einer Lichtquelle durchstrahlt und
- ein reelles Schattenbild der Probe auf einem Projektionsschirm erzeugt,
- wobei das Schattenbild der Probe auf dem Projektionsschirm von einer elektronischen Bildaufnahmeeinrichtung aufgenommen und dann einer Bildbearbeitung der Kontrast von Schlieren festgestellt wird und
- die an dem jeweiligen Material gemessenen Bildkontraste mit den Bildkontrasten eines Schattenbildes von Schlierenmustern in einer Musterprobe verglichen und man
- anhand des Vergleichsergebnisses die Schlieren in der Probe des optischen Materials bewertet, wobei in
- einem zweiten Schritt mittels polarisiertem Laserlicht anhand von Spannungsdoppelbrechung eine Bestimmung von lokalen Defekten und Strukturfehlern mit einer Ortsauflösung von mindestens 0,5 mm erfolgt, und wobei in
- einem dritten Schritt eine interferometrische Bestimmung von Materialfehlern erfolgt.

2. Verfahren nach Anspruch 1, **dadurch gekennzeichnet, dass** die Ortsauflösung im zweiten und/oder dritten Schritt höher als 0,2 mm ist.

3. Verfahren nach einem der vorhergehenden Ansprüche, **dadurch gekennzeichnet, dass** die Ortsauflösung im zweiten und/oder dritten Schritt höher als 0,1 mm ist.

4. Verfahren nach einem der vorhergehenden Ansprüche, **dadurch gekennzeichnet, dass** alle Messungen an einer Scheibe des optischen Materials mit einer polierten Oberfläche erfolgen.

5. Verfahren nach einem der vorhergehenden Ansprüche, **dadurch gekennzeichnet, dass** das Material ein Glas oder ein Kristall, insbesondere ein Alkali- oder Erdalkalihalogenidkristall oder -oxidkristall ist.

6. Verfahren nach einem der vorhergehenden Ansprüche, **dadurch gekennzeichnet, dass** das Material nur dann einer Messung gemäß dem zweiten oder dritten Schritt unterworfen wird, wenn es im vorhergehenden Schritt vorgegebene Mindestanforderungen bezüglich der Fehlerfreiheit erfüllt hat.

7. Verfahren nach einem der vorhergehenden Ansprüche, **dadurch gekennzeichnet, dass** aus den Materialien mit entsprechend geringen lokalen Strukturen ein optisches Element hergestellt wird.

8. Verfahren nach einem der vorhergehenden Ansprüche, **dadurch gekennzeichnet, dass** es zur Herstellung von Linsen, Prismen, optischen Fenstern sowie optischen Komponenten für die DUV-Lithographie, Steppern, Excimerlasern, Wafern, Computerchips, sowie integrierten Schaltungen und elektronischen Geräten, die solche Chips enthalten, verwendet wird.

## Claims

1. Method for determining local structures in optical materials, in particular in crystals, **characterized in that**
- a first step involves carrying out a visual determination of striae in the material by
- radiating through it divergent light from a light source and
- generating a real shadow image of the sample on a projection screen,
- the shadow image of the sample on the projection screen being recorded by an electronic image recording device and the contrast of striae then being ascertained in an image processing, and
- the image contrasts measured on the respective material are compared with the image contrasts of a shadow image of striae patterns in a pattern sample, and
- the striae in the sample of the optical material are assessed on the basis of the comparison result,
- a second step involving effecting a determination of local defects and structural faults with a spatial resolution of at least 0.5 mm by means of polarized laser light on the basis of stress birefringence, and
- a third step involving effecting an interferometric determination of material faults.

2. Method according to Claim 1, **characterized in that** the spatial resolution in the second and/or third step is higher than 0.2 mm.

3. Method according to one of the preceding claims, **characterized in that** the spatial resolution in the second and/or third step is higher than 0.1 mm.

4. Method according to one of the preceding claims, **characterized in that** all the measurements are effected on a disc of the optical material with a polished surface.

5. Method according to one of the preceding claims, **characterized in that** the material is a glass or a crystal, in particular an alkali metal or alkaline earth metal halide crystal or oxide crystal.

6. Method according to one of the preceding claims, **characterized in that** the material is subjected to a measurement in accordance with the second or third step only when it has fulfilled predetermined minimum requirements with regard to freedom from faults in the preceding step.

7. Method according to one of the preceding claims, **characterized in that** an optical element is produced from the materials with correspondingly small local structures.

8. Method according to one of the preceding claims, **characterized in that** it is used for producing lenses, prisms, optical windows and also optical components for DUV lithography, steppers, excimer lasers, wafers, computer chips, and also integrated circuits and electronic devices which contain such chips.

## Revendications

1. Procédé pour déterminer des structures locales dans des matériaux optiques, notamment dans les cristaux, **caractérisé en ce que**
- une détermination visuelle des ondes dans le matériau est effectuée au cours d'une première étape **en ce**
- **qu'**il est traversé par de la lumière divergente provenant d'une source de lumière et
- génère une silhouette réelle de l'échantillon sur un écran de projection,
- la silhouette de l'échantillon sur l'écran de projection étant enregistrée par un dispositif d'enregistrement d'image électronique et un traitement de l'image du contraste des ondes étant ensuite déterminé et
- les contrastes d'image mesurés sur le matériau correspondant étant comparés avec les contrastes d'image d'une silhouette de modèles d'ondes dans un modèle d'échantillon et
- les ondes dans l'échantillon de matériau optique étant évaluées au moyen du résultat de la comparaison,
- une détermination des défauts locaux et des défauts de structure avec une résolution de positionnement minimale de 0,5 mm ayant lieu au cours d'une deuxième étape au moyen d'une lumière laser polarisée à l'aide de biréfringence par compression et
- une détermination par interférométrie des défauts du matériau ayant lieu au cours d'une troisième étape.

2. Procédé selon la revendication 1, **caractérisé en ce que** la résolution de positionnement dans la deuxième et/ou la troisième étape est supérieure à 0,2 mm.

3. Procédé selon l'une des revendications précédentes, **caractérisé en ce que** la résolution de positionnement dans la deuxième et/ou la troisième étape est supérieure à 0,1 mm.

4. Procédé selon l'une des revendications précédentes, **caractérisé en ce** toutes les mesures sont effectuées sur un disque de matériau optique muni d'une surface polie.

5. Procédé selon l'une des revendications précédentes, **caractérisé en ce que** le matériau est un verre ou un cristal, notamment un cristal halogéné alcalinoterreux ou un cristal oxydé alcalin ou alcalinoterreux.

6. Procédé selon l'une des revendications précédentes, **caractérisé en ce que** le matériau n'est soumis à une mesure selon la deuxième ou la troisième étape que si, au cours de l'étape précédente, il a satisfait aux exigences minimales prédéfinies en matière d'absence de défauts.

7. Procédé selon l'une des revendications précédentes, **caractérisé en ce qu'**un élément optique est fabriqué à partir des matériaux ayant des structures locales faibles en conséquence.

8. Procédé selon l'une des revendications précédentes, **caractérisé en ce qu'**il est utilisé pour fabriquer des lentilles, des prismes, des fenêtres optiques ainsi que des composants optiques pour la lithographie DUV, des piqueuses, des lasers excimer, des galettes en silicium, des puces pour ordinateur ainsi que des circuits intégrés et des appareils électroniques qui contiennent de telles puces.
